# EUROPEAN PATENT APPLICATION

(11) **EP 1 073 027 A1**
(43) Date of publication of application: **31.01.2001**
(21) Application number: 00306170.2
(22) Date of filing: 20.07.2000
(51) Int. Cl.: G08C 23/04, G08C 19/28, H03J 1/00, H03J 9/06

(54) **System for activating and deactivating remote control devices**

(30) Priority: 29.07.1999 GB 9917807
(71) Applicant: Pace Micro Technology PLC, Saltaire, Shipley, BD18 3LF (GB)
(72) Inventor: Woodhouse, David Andrew, Haworth, West Yorkshire BD22 8HG (GB)
(74) Representative: Wood, Graham

(57) **Abstract**

The invention relates to the usage of a remote control device to generate signals for the control of electrical apparatus capable of receiving said signals and processing the same into a control function for the apparatus. The invention allows for the selective deactivation and activation of the remote control device by requiring the depression of a key or sequence of keys in a predetermined manner thereby preventing the unauthorised use of the remote control device by persons not being aware of the required key or key sequence to activate the remote control device.

## Description

The invention to which this invention relates is to a remote control device of the type which is commonly provided with electrical apparatus to allow the remote operation of the apparatus such as by transmission of infrared, ultrasonic, or other signals to the apparatus.

The provision of remote control devices to allow the operation of electrical apparatus by a user of the same from a remote location so that they are not required to actually go to the apparatus to control the same is well known and indeed most electrical apparatus of a particular type, such as television sets, broadcast data receivers, compact disc players and the like are provided with a remote control device as standard. As such, the general public is now generally aware of the operation of a remote control device and it is found that such devices are particularly attractive to relatively young children who, although they may not be able to operate the remote control device in a manner to provide designated selections, do find the device and the keys and the fact that the device can cause a change in, for example, music which is heard or a television display, attractive. However, when children operate the remote control devices in a manner which is random, it can be irritating to other persons who may be attempting to watch a television programme or listen to some music and the operation of the remote control in a random fashion causes the watching or listening to be interrupted, sometimes frequently.

It is known from previous patents that it is possible to allow some form of control with the use of remote control devices, however these are either directed towards the ability to allow a remote control device to be activated to access restricted material, whereas other remote controls are not; or are directed towards the ability to use the remote control device to transmit secure data in a particular format Yet further it is known to be able to use the remote control device to change the condition of the electrical apparatus for which it is provided into a locked condition. However none of the prior art of which the applicant is aware discloses the ability to move the remote control device itself between activated and deactivated conditions.

The aim of the present invention is to allow the remote control device utility to be maintained while at the same time restricting or preventing the unauthorised and random use of the remote control, especially by children.

In a first aspect of the invention there is provided a remote control device with means for selecting the mode and/or function and/or adjustment of a function of an item of electrical apparatus which has the capability to receive and interpret a signal from the remote control device, said signal from the remote control device generated by the depression of one or a number of keys provided on the device by the user and wherein, in order to generate a signal from the remote control device, the user is required to depress a key or keys in a predesignated sequence to render the remote control device operational and then allow the generation of a signal.

In one embodiment, the remote control device is activated and the selection executed if a key is pressed in a first instance and then pressed again within a designated time thereafter. In one embodiment the same key is required to be depressed in the first and second instances; however in an alternative embodiment, the depression of one key on the remote control device then allows the activation of the device and the subsequent selection can be made using any of the keys of the remote control device as long as they are depressed within the pre-designated time period. In an alternative arrangement, the depression of the key in the first instance is required to be for a pre-designated period of time before the remote control device is rendered operational.

In a yet further embodiment, the user is required to enter a predesignated number code by depression of the appropriate keys on the remote control device and whereafter the device is operational for a predetermined period of time by the subsequent normal selection of keys.

It is therefore envisaged that the provision of this requirement to depress keys in a predesignated configuration and within a predesignated time will overcome the ability for young children to cause a change in function or a mode of electrical apparatus simply by playing with the device. There is a further ability and improvement that no additional device is required to be fitted to a remote control device and no locking mechanism is required.

It is also envisaged that it will be of benefit for the remote control device to be operational in a normal or conventional mode and also to be adjustable by user selection, to operate in a mode whereby the required key depression is required to stop.

In a further aspect of the invention there is provided a remote control device for use with electrical apparatus, said remote control device including a plurality of keys, and said remote control device bringing about a change in the function/control or status of the electrical apparatus when one or more of the keys are depressed to generate a signal which is received and processed by the electrical apparatus and characterised in that there is provided a locking means which , when activated prevents the remote control from generating a signal which can alter the function/control or status of the electrical apparatus and said locking means is activated and/or deactivated by the selective depression of one or more of the said function/control or status in a predetermined sequence and/or period of time.

A specific embodiment of the invention is now described with reference to the accompanying drawings, wherein:-
Fig. 1 illustrates a method of activating a remote control in accordance with one embodiment;
Fig. 2 illustrates a method of activating a remote control in accordance with a second embodiment; and
Fig. 3 illustrates a method of activating a remote control device in accordance with a third embodiment of the invention.

Most electrical apparatus devices such as television sets, video set recorders and broadcast data receivers are provided with a remote control handset. In using the remote control device , the user ensures that the signal which is transmitted by the remote control device, typically an infra red signal, can be received by the apparatus. The configuration of the signal which is then generated is dependent upon the key of a range of marked keys on the remote control device which is selected by the user. In normal use, the remote control device can be easily and conveniently used however if the same is used by a child or other person to change the functions of the apparatus in a random or unauthorised manner it can become irritating for the person using the apparatus.

However, in accordance with the invention, if the user is irritated by unauthorised or random use of the remote control device they can use the remote control device according to the present invention to advantage. In accordance with the invention, the remote control device , when not in use for a predesignated period of time, moves to a deactivated mode in which the depression of the keys in a random manner will not generate a control signal. Instead, to activate the remote control device the depression of a key or sequence of keys is required to be undertaken.

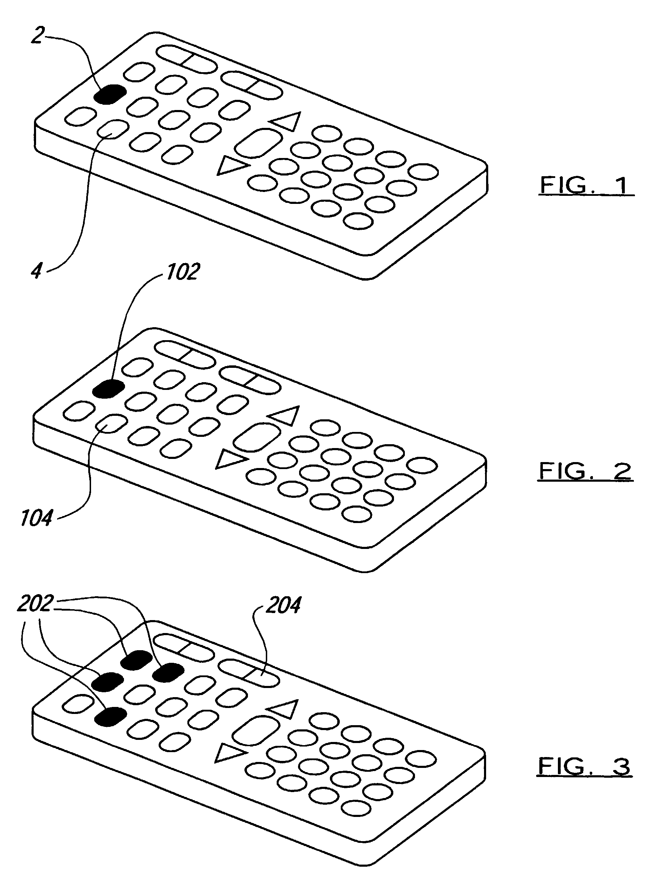

Referring now to Fig. 1 a remote control device is illustrated with a range of control keys shown. In this embodiment, to activate the remote control device the key 2 is required to be depressed twice within a predesignated time period and if the depression is sensed, a processor within the remote control device or if a signal is transmitted from the remote control device, a processor in the electrical apparatus, checks that the correct key has been pressed and that the same has been pressed the number of times required to match the predesignated activation requirement held in a memory in the remote control device or electrical apparatus. If the correct key has been pressed the correct number of times, the remote control device is activated, following which another key, in this case 4, can be pressed in a conventional manner to cause a change in condition signal to be sent from the remote control device to change the condition of the apparatus, in this case to change a channel being viewed on a television set. If the key 4 or another key is not depressed within a time interval, say 5 seconds, from the double depression of the key 2 to activate the device, then any subsequently depressed key will not have an effect on the function of the apparatus and it is again necessary to depress the key 2 twice to activate the device. Equally, all other key presses which take place within the set time period of say 5 seconds, will cause a change in function of the apparatus in a normal manner or if, having been activated, keys continue to be pressed within a predesignated time period from the previous key depression the remote control device will remain in an activated mode.

An advantage of the system shown in Fig. 1 is that no additional hardware modification of the electrical apparatus or the remote control device is required and the system can be implemented by changing the software in the electrical apparatus or in the remote control apparatus.

Fig. 2 illustrates an alternative embodiment of remote control device operation whereby the user depresses a key 102 for a predetermined period of time and then releases the same. If the correct key is pressed for the a period of time equalling or exceeding the predesignated period of time then the activation of the remote control unit is achieved. Any subsequent key depressions which take place within a set time period are then performed with the remote control activated. If no key depressions are detected within a set time period thereafter it is assumed by the system that the user has finished with the remote control device and it is then deactivated. Again, no hardware modification to the remote control handset is required and can be implemented by changing the software.

Fig. 3 illustrates a yet further alternative embodiment of the invention wherein the user is required to depress a number of keys 202 in a required sequence. If the correct sequence is entered then the remote control device is activated and the subsequent depression of keys within a predetermined period of time allows a normal operation of the remote handset.

It should also be appreciated that the same or a further key depression or keys depression sequence can be followed by the user to move the remote control device from an active to deactivated condition.
Thus, the system and apparatus of the present invention provides a means for preventing young children or others from randomly operating a remote control device and has the advantage of also being easy to implement by a change of software and requires no change to the remote control device or electrical apparatus hardware. It is also envisaged that the remote control device can be provided to operate in a conventional manner in which the activation and deactivation feature of the remote control device is not available or in a manner in accordance with the invention, as required by the user of the apparatus.

## Claims

1. A remote control device with means for selecting the mode and/or function and/or adjustment of a function of an item of electrical apparatus which has the capability to receive and interpret a signal from the remote control device, said signal from the remote control device generated by the depression of one or a number of keys provided on the device by the user and characterised in that in order to generate a signal from the remote control device, the user is required to depress a key or keys in a predesignated sequence to render the remote control device operational and then allow the generation of a signal from the remote control device by the subsequent depression of an appropriate key or keys.

2. A remote control device according to claim 1 characterised in that the remote control device is activated and the selection executed if a key is pressed in a first instance and a further key is pressed within a designated time period thereafter.

3. A remote control device according to claim 2 characterised in that the same key is required to be depressed in the first and second instances.

4. A remote control device according to claim 1 characterised in that the depression of a designated key on the remote control device allows the activation of the device and the subsequent selection can be made using any of the keys of the remote control device within a pre-designated time period from depression of the first key.

5. A remote control device according to claim 4 characterised in that the subsequent depression of keys on the remote control can allow a number of selections to be made, if the keys are depressed within a predesignated time period from the previous key depression.

6. A remote control device for use with electrical apparatus, said remote control device including a plurality of keys, and said remote control device bringing about a change in the function/control or status of the electrical apparatus when one or more of the keys are depressed to generate a signal which is received and processed by the electrical apparatus and characterised in that there is provided a locking means which , when activated prevents the remote control from generating a signal which can alter the function/control or status of the electrical apparatus and said locking means is activated and/or deactivated by the selective depression of one or more of the said function/control or status in a predetermined sequence and/or period of time.
